# EUROPEAN PATENT APPLICATION

(11) **EP 3 125 251 A1**
(43) Date of publication of application: **01.02.2017**
(21) Application number: 14890817.1
(22) Date of filing: 23.09.2014
(51) Int. Cl.: G11C 29/42

(54) **HAMMING CODE-BASED DATA ACCESS METHOD AND INTEGRATED RANDOM ACCESS MEMORY**

(30) Priority: 30.04.2014 CN 201410183884
(71) Applicant: Sanechips Technology Co., Ltd., Nanshan District Shenzhen, Guangdong 518055 (CN)
(72) Inventor: GUO, Bin, Shenzhen Guangdong 518085 (CN)
(74) Representative: Benson, Christopher
(86) International application number: PCT/CN2014/087226
(87) International publication number: WO 2015/165202

(57) **Abstract**

The present invention provides a method for writing/reading data based on hamming code and an integrated random access memory (IRAM) using the method. Herein, the method for writing data includes: analyzing a received reading/writing instruction to obtain a reading/writing state of the reading/writing instruction; and when it is determined that the reading/writing state is in a writing state, performing error checking and correcting ECC coding on data to be stored that are carried in the reading/writing instruction to generate a corresponding first check code, and storing the data to be stored and the first check code.

## Description

### Technical Field

The present invention relates to the technical field of data storage, and in particular, to a method for writing/reading data based on hamming code and an integrated random access memory IRAM for realizing the above method.

### Background

In the process of realizing the technical scheme of the embodiment of the application, the inventor of the application has at least found the following technical problems in the related art:
the error checking and correcting ECC checking is developed on the basis of the traditional parity check, which mainly uses the row and column parity check information of the data block to generate the ECC code, checks out whether the given data block is distorted and has a capacity of automatic error correction to a bit of the data block. It overcomes the limitation that the traditional parity check can only detect the error of the odd bit of the data block, the check code is lengthy, and the error cannot be corrected.

In the computer system, it is an important basis of the normal work of the computer to maintain the correctness and consistency of the data. While during the process of the storage or transmission of the data, due to interference, device failure and other reasons, there is a possibility of data distortion. Therefore, it is necessary to take some measures to timely detect and correct the distortion of the data. At present, the IRAM, as a commonly used large capacity storage device, can only be used for the large capacity data storage, it cannot guarantee the accuracy of the data written or data read by itself, and cannot make correction when there is a data error.

### Summary of the Invention

In view of this, the embodiment of the present invention is expected to provide a method for writing/reading data based on hamming code and an IRAM to realize the method, which solves the problem that the IRAM cannot guarantee the accuracy of its written data or read data and cannot perform the error correction when there is an error in the data.

The technical scheme of the present invention is realized as follows:
the embodiment of the present invention provides a method for writing data based on hamming code, including: analyzing a received reading/writing instruction to obtain a reading/writing state of the reading/writing instruction; and when determining that the reading/writing state is a writing state, performing error checking and correcting (ECC) coding on data to be stored that are carried in the reading/writing instruction to generate a corresponding first check code, and storing the data to be stored and the first check code.

In the above scheme, a format conversion is performed on the reading/writing instruction before analyzing the received reading/writing instruction.

In the above scheme, it is judged whether there are invalid data in the data to be stored before performing the ECC coding on the data to be stored that are carried in the reading/writing instruction; in a case that there are invalid data in the data to be stored, storage data corresponding to an operation address carried by the reading/writing instruction are obtained, and valid data to be stored are generated according to the storage data.

The embodiment of the present invention further provides a method for reading data based on hamming code, including: analyzing a received reading/writing instruction to obtain a reading/writing state of the reading/writing instruction; and when determining that the reading/writing state is a reading state, obtaining data to be obtained according to the reading/writing instruction, detecting the data to be obtained by using error checking and correcting ECC coding to obtain a detection result; and directly sending the data to be obtained, or sending the data to be obtained after error correction, or triggering an alarm according to the detection result.

In the above scheme, a format conversion is performed on the reading/writing instruction before analyzing the received reading/writing instruction.

In the above scheme, the data to be obtained and a first check code corresponding to the data to be obtained are obtained according to the reading/writing instruction, and the ECC coding is performed on the data to be obtained, to generate a second check code; accordingly, detecting the data to be obtained by using the ECC coding to obtain the detection result, and directly sending the data to be obtained, or sending the data to be obtained after the error correction, or triggering an alarm according to the detection result includes: performing an XOR operation on the first check code and the second check code to generate an XOR result; and directly sending the data to be obtained, or sending the data to be obtained after the error correction, or triggering an alarm according to the XOR result.

In the above scheme, directly sending the data to be obtained, or sending the data to be obtained after the error correction, or triggering an alarm according to the detection result is specifically: in case one: when the XOR result is all-0 or there is a single bit 1, then directly sending the data to be obtained; in case two: when a number of 0s and a number of 1s in the XOR result are equal, then sending the data to be obtained after the error correction; if a case is not the case one or the case two, then trigger an alarm.

The embodiment of the present invention further provides an integrated random access memory IRAM for writing data based on hamming code, including: a first control module, a first error checking and correcting ECC module and a first storage module; herein, the first control module is configured to analyze a received reading/writing instruction to obtain a reading/writing state of the reading/writing instruction; the first ECC module is configured to, when determining that the reading/writing state is a writing state, perform error checking and correcting ECC coding on data to be stored that are carried in the reading/writing instruction to generate a corresponding first check code; and the first storage module is configured to store the data to be stored and the first check code.

In the above scheme, the first control module is further configured to perform a format conversion on the reading/writing instruction.

In the above scheme, the first ECC module includes: a first judgment submodule and a first coding submodule; herein, the first judgment submodule is configured to judge where there are invalid data in the data to be stored, in a case that there are invalid data in the data to be stored, obtain storage data corresponding to an operation address carried by the reading/writing instruction, and generate valid data to be stored according to the storage data; and the first coding submodule is configured to perform the ECC coding on the data to be stored to generate a first check code.

The first control module, the first ECC module, the first storage module, the first judgment submodule, the first coding submodule can be realized by a Central Processing Unit CPU, a Digital Signal Processor (DSP) or a Field-Programmable Gate Array FPGA during the implementation process.

The embodiment of the present invention further provides an integrated random access memory (IRAM) for reading data based on hamming code, including: a second control module, a second error checking and correcting (ECC) module and a second storage module; herein, the second control module is configured to analyze a received reading/writing instruction to obtain a reading/writing state of the reading/writing instruction; the second ECC module is configured to, when determining that the reading/writing state is a reading state, obtain data to be obtained according to the reading/writing instruction, detect the data to be obtained by using error checking and correcting ECC coding to obtain a detection result, and directly send the data to be obtained, or send the data to be obtained after error correction, or trigger an alarm according to the detection result; and the second storage module is configured to store the data to be obtained and a first check code corresponding to the data to be obtained.

In the above scheme, the second control module is further configured to perform a format conversion on the reading/writing instruction.

In the above scheme, the second ECC module includes: a second coding submodule and a check submodule; herein, the second coding submodule is configured to obtain the data to be obtained and a first check code corresponding to the data to be obtained according to the reading/writing instruction, and perform the ECC coding on the data to be obtained, to generate a second check code; and the check submodule is configured to perform an XOR operation to the first check code and the second check code to generate an XOR result, directly send the data to be obtained, or send the data to be obtained after error correction, or trigger an alarm according to the XOR result.

In the above scheme, the check submodule is configured specifically to: in case one, when the XOR result is all-0 or there is a single bit 1, then directly send the data to be obtained; in case two: when a number of 0s and a number of 1s in the XOR result are equal, then send the data to be obtained after the error correction; if a case is not the case one or the case two, then trigger an alarm.

The second control module, the second ECC module, the second storage module, the second coding submodule and the check submodule can be realized by a Central Processing Unit CPU, a Digital Signal Processor DSP or a Field-Programmable Gate Array FPGA during the implementation process.

The embodiment of the present invention further provides a method for writing/reading data based on hamming code and an IRAM to realize the method. The method for reading data includes: analyzing a received reading/writing instruction to obtain a reading/writing state of the reading/writing instruction; and when determining that the reading/writing state is a writing state, performing the ECC coding on data to be stored that are carried in the reading/writing instruction to generate a corresponding first check code, and storing the data to be stored and the first check code. The method for reading data includes: when determining that the reading/writing state is a reading state, obtaining data to be obtained according to the reading/writing instruction, detecting the data to be obtained by using the ECC coding to obtain a detection result, and directly sending the data to be obtained, or sending the data to be obtained after error correction, or triggering an alarm according to the detection result.

By adopting the embodiment of the present invention, the problem that the IRAM cannot guarantee the accuracy of its written data or read data and cannot perform the error correction when there is an error in the data, is solved. At the same time, the method of the embodiment of the present invention adopts the Hamming code, overcomes the defection that the traditional parity check can only detect the error of the parity bit of the data block, the check code is lengthy, and the error cannot be corrected, completes the function of correcting the single bit error and detecting the two bit error for the IRAM through the ECC check mode, enables the IRAM itself to have the ability of recognizing the data error, and issues an alarm when there is an error when reading the data, so as to improve the accuracy and reliability of storing the data by the IRAM.

### Brief Description of Drawings

FIG. 1 is a flow chart of a method for writing data based on hamming code provided by an embodiment of the present invention;
FIG. 2 is a flow chart of a method for reading data based on hamming code provided by an embodiment of the present invention;
FIG. 3 is a flow chart of a method for accessing data based on hamming code provided by an embodiment of the present invention;

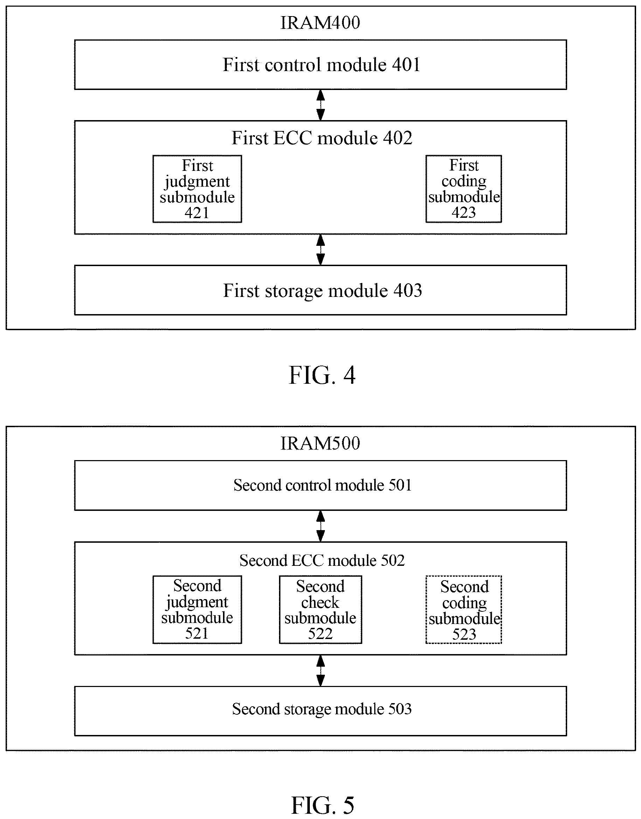

FIG. 4 is a structure diagram of an IRAM for writing data based on hamming code provided by an embodiment of the present invention;
FIG. 5 is a structure diagram of an IRAM for reading data based on hamming code provided by an embodiment of the present invention;
FIG. 6 is a structure diagram of an IRAM for writing/reading data based on hamming code provided by an embodiment of the present invention.

### Specified Embodiments

In an embodiment of the present invention, a received reading/writing instruction is analyzed to obtain a reading/writing state of the reading/writing instruction; and the ECC coding is performed on data to be stored that are carried in the reading/writing instruction when determining that the reading/writing state is a writing state, to generate a corresponding first check code, and the data to be stored and the first check code are stored; data to be obtained are obtained according to the reading/writing instruction when determining that the reading/writing state is a reading state, the data to be obtained are detected by using the ECC coding to obtain a detection result; and the data to be obtained are sent directly, or the data to be obtained are sent after error correction, or an alarm is triggered according to the detection result.

The present invention is further illustrated in details through the accompanying drawings and specific embodiments.

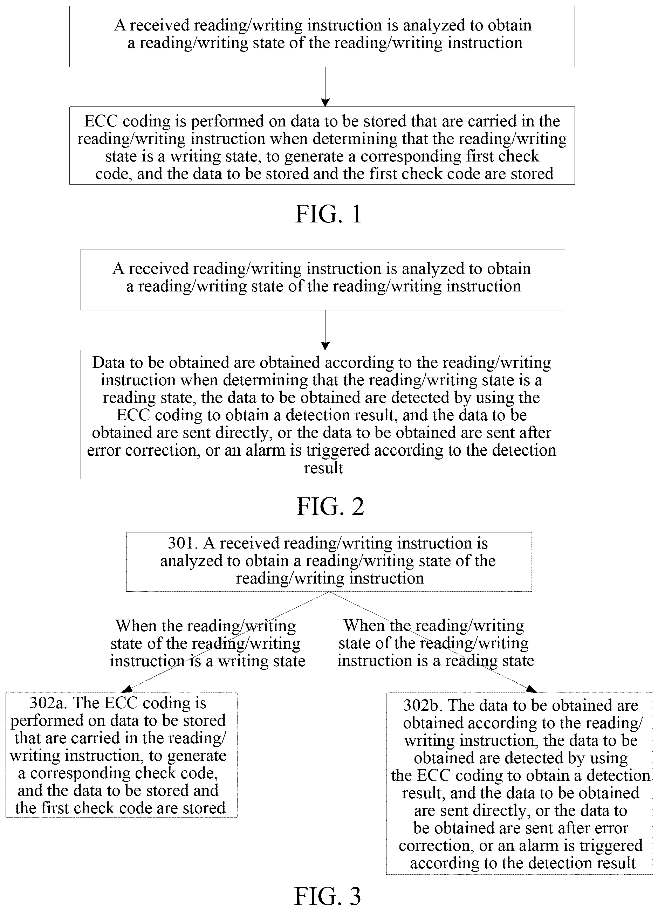

FIG. 1 is a flow chart of a method for writing data based on hamming code provided by an embodiment of the present invention. As shown in the figure, the method includes the following steps:
in step 101, a received reading/writing instruction is analyzed to obtain a reading/writing state of the reading/writing instruction;
specifically, the IRAM analyzes the received reading/writing instruction when receiving the reading/writing instruction, to obtain the reading/writing state of the reading/writing instruction; when the received reading/writing instruction is a writing instruction and the reading/writing state of the reading/writing instruction is a writing state, then at this time, the data are written to the IRAM; here, specifically the data are written to a Static random Access Memory (SRAM) in the IRAM; here the data will be written to the IRAM are called as data to be stored, and also can be called as the data to be written.

The IRAM performs a format conversion on the reading/writing instruction before analyzing the received reading/writing instruction. Here, the IRAM converts a received Advanced extensible Interface AXI command based on an Advanced Microcontroller Bus Architecture AMBA protocol to a reading/writing instruction corresponding to an SRAM interface used within the IRAM, and the specific conversion process is to convert a five-channel AXI protocol to a single-channel SRAM protocol; here, the specific conversion process is same with the conversion method of the related art, and will no longer go into detail.

The converted SRAM command includes: a reading/writing enabled (wen), representing that the reading/writing is enabled, herein, the high level is for a reading operation, and the low level is for a writing operation; a chip selection enabled (cen), representing that the chip selection is enabled, herein, the low level is represented that the chip selection is valid; an address (addr), representing the address corresponding to the reading/writing operation; data (data), representing the written data corresponding to the writing operation or the data read out by the reading operation; and a valid bit number (byten), representing the valid bit number in the written data, herein, the low level is valid.

In step 102, the ECC coding is performed on data to be stored that are carried in the reading/writing instruction when determining that the reading/writing state is a writing state, to generate a corresponding first check code, and the data to be stored and the first check code are stored;
here, the wen received by the IRAM is a high level, and currently the writing operation is performed; at that time, the IRAM performs the ECC coding on the data to be stored which are carried by the reading/writing instruction; herein, the ECC coding performs the coding by adopting the hamming code.

The IRAM judges whether there are invalid data in the data to be stored before performing the ECC coding on data to be stored; in the case that there are invalid data in the data to be stored, storage data corresponding to an operation address carried by the reading/writing instruction are obtained, valid data to be stored are generated according to the storage data, and the ECC coding is performed on the valid data to be stored to generate a corresponding first check code; Here, when there are invalid data in the data to be stored, the current data to be stored are invalid data to be stored, and need to combine with the storage data stored at the corresponding operation address in the IRAM, so as to generate valid data to be stored. Here, when the data to be stared are all valid, ECC coding is performed directly on the data to be stored.
when the IRAM obtains the data to be stored, it is judged whether there are invalid data in the data to be stored according to a value of the byten carried by the reading/writing instruction; when the byten is all-0, it is indicated that the current data to be stored are all valid, and there is no invalid data; when the byten is not all-0, it is indicated that there are invalid data in the current data to be stored, and it is required to perform a "reading and rewriting operation"; that is to say, the storage data stored in the IRAM and stored by itself are obtained from the SRAM according to the operation address carried by the reading/writing instruction firstly, and the data corresponding to the data bits of which the byten is 0 in the data to be stored are updated into the storage data, to generate the valid data to be stored; here, the ECC coding is performed on the generated valid data to be stored to generate the first check code, and the valid data to be stored and the generated first check code are stored in the SRAM.

FIG. 2 is a flow chart of a method for reading data based on hamming code provided by an embodiment of the present invention. As shown in the figure, the method includes the following steps:
in step 201, a received reading/writing instruction is analyzed to obtain a reading/writing state of the reading/writing instruction;
specifically, the IRAM analyzes the received reading/writing instruction when receiving the reading/writing instruction, to obtain the reading/writing state of the reading/writing instruction; when the received reading/writing instruction is a reading command and the reading/writing state of the reading/writing instruction is a reading state, then at this time, the data are read from the IRAM; here, specifically the data are read from the SRAM of the IRAM, and the data read from the IRAM are called as the data to be obtained, and also can be called as the data to be read.

The IRAM performs a format conversion on the reading/writing instruction before analyzing the received reading/writing instruction. The specific conversion process is consistent with step 101; here, the difference with step 101 is that the levels of wen are different; herein, in step 101 the wen is the low level representing to perform the writing operation, and the wen in this step is high level representing to perform the reading operation.

In step 202, data to be obtained are obtained according to the reading/writing instruction when determining that the reading/writing state is a reading state, the data to be obtained are detected by using the ECC coding to obtain a detection result, and the data to be obtained are sent directly, or the data to be obtained are sent after error correction, or an alarm is triggered according to the detection result;
here, the IRAM further obtains the data to be obtained and the first check code corresponding to the data to be obtained according to the reading/writing instruction, and performs the ECC coding on the data to be obtained to generate a second check code; an XOR operation is performed on the first check code and the second check code to generate an XOR result after generating the second check code; and the data to be obtained are sent directly, or the data to be obtained are sent after the error correction, or an alarm is triggered according to the XOR result; herein, the XOR result includes multiple cases as follows: all-0, a single bit 1, the number of 0s and the number of 1s are equal, and other situations except the above cases; accordingly, sending the data to be obtained directly, or sending the data to be obtained after the error correction, or triggering an alarm according to the XOR result is specifically:
in case one: when the XOR result is all-0 or there is a single bit 1, then the data to be obtained are directly sent;
in case two: when the number of 0s and the number of 1s in the XOR result are equal, then the data to be obtained are sent after the error correction;
if it is not the case one or case two, then the alarm is triggered, to remind that the reading/writing instruction fails to read the data from the IRAM.

In the practical application, the data to be obtained in step 202 can be written into the IRAM through step 101, and are read when receiving the reading instruction; while now the first check code corresponding to the read data to be obtained is the first check code generated in step 102.

As shown in FIG. 1 and FIG. 2, the embodiment of the present invention provides a method for writing and reading data based on hamming code respectively, and in practical application, these two methods can be applied to one IRAM, to realize a method for writing/reading data based on hamming code, herein, the method includes the following steps:
in step 301: a received reading/writing instruction is analyzed to obtain a reading/writing state of the reading/writing instruction;
here, the IRAM analyzes the received reading/writing instruction when receiving the reading/writing instruction, the received reading/writing instruction can be a writing command and can also be a reading command; and a reading/writing state of the reading/writing instruction is a writing state when the received reading/writing instruction is a writing state, and the data are written into the IRAM; and the reading/writing state of the reading/writing instruction is a reading state when the received reading/writing instruction is a reading command, and the data are read from the IRAM.

The IRAM performs different operations according to the different reading/writing state of the received reading/writing instruction, and specifically, step 302a is performed when the reading/writing state of the reading/writing instruction is the writing state; and step 302b is performed when the reading/writing state of the reading/writing instruction is the reading state.

The step 302a is same with step 102, herein the ECC coding is performed on data to be stored that are carried in the reading/writing instruction, to generate a corresponding check code, and the data to be stored and the first check code are stored;

The step 302b is same with step 202, herein data to be obtained are obtained according to the reading/writing instruction, the data to be obtained are detected by using the ECC coding, and the data to be obtained are sent directly, or the data to be obtained are sent after error correction, or an alarm is triggered according to a detection result.

The IRAM can cache the reading/writing instruction according to the reading/writing state after obtaining the reading/writing state of the reading/writing instruction in step 101, step 201 and step 301; herein, the reading/writing instruction is cached by a first in first out mode; here, the reading/writing state is firstly cached, and a certain buffer time is left between the IRAM receiving the reading instruction and processing the reading/writing instruction, for the IRAM to process the reading/writing instruction, perform the processing such as coding and checking the data to be stored and the data to be obtained, etc. which occupies time cycles,, to avoid the problem that part of the reading/writing instructions are lost caused by a too fast speed for receiving the reading/writing instruction.

When the IRAM receives the reading/writing instruction, data transmission starting information for indicating to start to process the reading/writing instruction will be automatically generated, to indicate that the IRAM is currently processing the reading/writing instruction; after the IRAM stores the data to be stored, or sends the data to be obtained out or triggers the alarm, data transmission ending information for handshaking with the data transmission starting information is generated, to indicate that the current IRAM already completes the processing on the current reading/writing instruction, and it can start to process a new reading/writing instruction.

In the embodiment of the present invention, when the state of the read instruction is the writing state, the check code generated after the ECC code is performed on the data to be stored is the first check code; when the reading/writing instruction of which the reading/writing state is the reading state reads the data to be stored, the data to be stored are in the state of being read because the data to be stored are already stored in the IRAM at this time, and correspondingly, the data to be stored are the data to be obtained at this time.

In the practical application, the reading/writing state of the reading/writing instruction is determined by wen and cen together, and the IRAM does not have the reading/writing ability in the case that the cen is invalid; In the case that the cen is valid, the current reading/writing state is determined according to the level of the wen, herein, the high level is the reading operation, and the low level is the writing operation.

In order to realize the above method, the embodiment of the present invention provides an IRAM 400, which includes: a first control module 401, a first ECC module 402 and a first storage module 403; herein,
the first control module 401 is configured to analyze a received reading/writing instruction to obtain a reading/writing state of the reading/writing instruction.

The first control module 401 is further configured to perform a format conversion on the reading/writing instruction.

The first ECC module 402 is configured to perform the ECC coding on data to be stored that are carried in the reading/writing instruction when determining that the reading/writing state is a writing state, to generate a corresponding check code;

The first ECC module 402 includes: a first judgment submodule 421 and a first coding submodule 422; herein, the first judgment submodule 421 is configured to judge whether there are invalid data in the data to be stored, in the case that there are invalid data in the data to be stored, obtain storage data corresponding to an operation address carried by the reading/writing instruction, and generate valid data to be stored according to the storage data; and the first coding submodule 422 is configured to perform the ECC coding on the data to be stored to generate a first check code.

The first storage module 403 is configured to store the data to be stored and the first check code.

The embodiment of the present invention further provides an IRAM 500 for reading data based on hamming code, which includes: a second control module 501, a second ECC module 502 and a second storage module 503;
the second control module 501 is configured to analyze a received reading/writing instruction to obtain a reading/writing state of the reading/writing instruction.

The second control module 501 is further configured to perform a format conversion on the reading/writing instruction.

The second ECC module 502 is configured to obtain data to be obtained according to the reading/writing instruction when determining that the reading/writing state is a reading state, detect the data to be obtained by using the ECC coding, and directly send the data to be obtained, or send the data to be obtained after error correction, or trigger an alarm according to the detection result;
the second ECC module 502 includes: a second coding submodule 521 and a check submodule 522;
the second coding submodule 521 is configured to obtain the data to be obtained and a first check code corresponding to the data to be obtained according to the reading/writing instruction, and perform the ECC coding on the data to be obtained, to generate a second check code; and
the check submodule 522 is configured to perform an XOR operation on the first check code and the second check code to generate an XOR result, directly send the data to be obtained, or send the data to be obtained after error correction, or trigger an alarm according to the XOR result.

The check submodule 522 is specifically configured to: in case one: when the XOR result is all-0 or there is a single bit 1, then directly send the data to be obtained; in case two: when the number of 0s and the number of 1s in the XOR result are equal, then send the data to be obtained after the error correction; and if the case is not the case one or the case two, then trigger the alarm.

The second storage module 503 is configured to store the data to be obtained and a first check code corresponding to the data to be obtained.

In the practical application, the second ECC module also includes an error correction submodule 523, which is configured to perform error correction on the data to be obtained which require to be corrected and are sent by the check submodule 522, and send out the data to be obtained after the error correction.

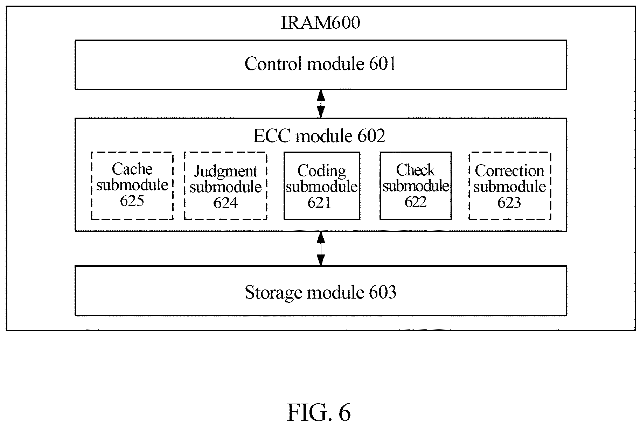

The embodiment of the present invention further provides an IRAM 600 for storing/reading data based on hamming code, which includes, as shown in FIG. 6: a control module 601, an ECC module 602 and a storage module 603;
the control module 601 is configured to analyze a received reading/writing instruction to obtain a reading/writing state of the reading/writing instruction.

The control module 601 is further configured to perform a format conversion on the reading/writing instruction.

The ECC module 602 is configured to perform the ECC coding on data to be stored that are carried in the reading/writing instruction when the reading/writing state is a writing state, to generate a corresponding first check code; obtain the data to be obtained according to the reading/writing instruction when the reading/writing state is a reading state, detect the data to be obtained by using the ECC coding, and send the data to be obtained directly, or send the data to be obtained after error correction, or trigger an alarm according to the detection result; herein, for the same data, it is called the data to be written in the writing state and called the data to be obtained in the reading state.

The ECC module 602 includes: a coding submodule 621 and a check submodule 622;
the coding submodule 621 is configured to perform the ECC coding on data to be stored that are carried in the reading/writing instruction when the reading/writing state is a writing state, to generate a corresponding first check code; and obtain the data to be obtained and the first check code corresponding to the data to be obtained according to the reading/writing instruction when the reading/writing state is the reading state, and perform the ECC coding on the data to be obtained to generate the second check code;
the check submodule 622 is configured to perform an XOR operation on the first check code corresponding to the data to be obtained and the second check code to generate an XOR result, directly send the data to be obtained, or send the data to be obtained after error correction, or trigger an alarm according to the XOR result.

Here, the check submodule 622 is specifically configured to: in case one: when the XOR result is all-0 or there is a single bit 1, then directly send the data to be obtained; in case two: when the number of 0s and the number of 1s in the XOR result are equal, then send the data to be obtained after the error correction; and if the case is not the above case one or case two, then trigger the alarm.

The storage module 603 is configured to store the data to be obtained and a first check code corresponding to the data to be obtained.

As shown in FIG. 6, the ECC module 602 also includes a judgment submodule 624, and an error correction submodule 623, which is configured to perform error correction on the data to be obtained sent by the check submodule 622, and send out the data to be obtained after the error correction.

As shown in FIG. 6, the ECC module 602 further includes a judgment submodule 624, configured to judge whether there are invalid data in the data carried by the reading/writing instruction when the reading/writing state is the writing state; in the case that there are invalid data in the data to be stored, obtain storage data corresponding to an operation address carried by the reading/writing instruction, and generate valid data to be stored according to the storage data.

As shown in FIG. 6, the ECC module 602 further includes: a cache submodule 625, configured to cache the reading/writing instruction according to the reading/writing state before performing the ECC coding on the data to be stored carried by the reading/writing instruction to generate the corresponding first check code or obtaining the data to be obtained according to the reading/writing instruction.

In the practical application, the device or system device provided by the present invention can be used as a separate system, and can also be an existing terminal such as a personal computer PC adding a logic unit to complete different functions.

When the logic unit is added in the PC, the first control module 401, the first ECC module 402, the first storage module 403, the second control module 501, the second ECC module 502, the second storage module 503, the control module 601, the ECC control module 602 and the storage module 603 can be realized by a Central Processing Unit CPU, a Digital Signal Processor DSP, or a Field Programmable Gate Array FPGA located in the PC.

The above description is only for preferred embodiments of the present invention, and is not used to limit the protection scope of the present invention.

### Industrial Applicability

By adopting the embodiment of the present invention, the problem that the IRAM cannot guarantee the accuracy of its written data or read data and cannot perform the error correction when there is an error in the data, is solved. At the same time, the method of the embodiment of the present invention adopts the Hamming code, overcomes the defection that the traditional parity check can only detect the error of the parity bit of the data block, the check code is lengthy, and the error cannot be corrected, completes the function of correcting the single bit error and detecting the two bit error for the IRAM through the ECC check mode, enables the IRAM itself to have the ability of recognizing the data error, and issues an alarm when there is an error when reading the data, so as to improve the accuracy and reliability of storing the data by the IRAM.

## Claims

1. A method for writing data based on hamming code, comprising:
analyzing a received reading/writing instruction to obtain a reading/writing state of the reading/writing instruction; and
when determining that the reading/writing state is a writing state, performing error checking and correcting ECC coding on data to be stored that are carried in the reading/writing instruction to generate a corresponding first check code, and storing the data to be stored and the first check code.

2. The method according to claim 1, further comprising: performing a format conversion on the reading/writing instruction before analyzing the received reading/writing instruction.

3. The method according to claim 1, further comprising: judging whether there are invalid data in the data to be stored before performing the ECC coding on the data to be stored that are carried in the reading/writing instruction; in a case that there are invalid data in the data to be stored, obtaining storage data corresponding to an operation address carried by the reading/writing instruction, and generating valid data to be stored according to the storage data.

4. A method for reading data based on hamming code, comprising:
analyzing a received reading/writing instruction to obtain a reading/writing state of the reading/writing instruction; and
when determining that the reading/writing state is a reading state, obtaining data to be obtained according to the reading/writing instruction, detecting the data to be obtained by using error checking and correcting ECC coding to obtain a detection result; and directly sending the data to be obtained, or sending the data to be obtained after error correction, or triggering an alarm according to the detection result.

5. The method according to claim 4, further comprising: performing a format conversion on the reading/writing instruction before analyzing the received reading/writing instruction.

6. The method according to claim 4, further comprising: obtaining the data to be obtained and a first check code corresponding to the data to be obtained according to the reading/writing instruction, and performing ECC coding on the data to be obtained, to generate a second check code;
accordingly, said detecting the data to be obtained by using ECC coding to obtain a detection result, and directly sending the data to be obtained, or sending the data to be obtained after the error correction, or triggering an alarm according to the detection result comprises:
performing an XOR operation on the first check code and the second check code to generate an XOR result; and directly sending the data to be obtained, or sending the data to be obtained after the error correction, or triggering an alarm according to the XOR result.

7. The method according to claim 6, wherein, said directly sending the data to be obtained, or sending the data to be obtained after the error correction, or triggering an alarm according to the detection result is specifically:
in case one: when the XOR result is all-0 or there is a single bit 1, then directly sending the data to be obtained;
in case two: when a number of 0s and a number of 1s in the XOR result are equal, then sending the data to be obtained after the error correction;
if a case is not the case one or the case two, then triggering an alarm.

8. An integrated random access memory IRAM for writing data based on hamming code, comprising: a first control module, a first error checking and correcting ECC module and a first storage module; wherein,
the first control module is configured to analyze a received reading/writing instruction to obtain a reading/writing state of the reading/writing instruction;
the first ECC module is configured to, when determining that the reading/writing state is a writing state, perform error checking and correcting ECC coding on data to be stored that are carried in the reading/writing instruction to generate a corresponding first check code; and
the first storage module is configured to store the data to be stored and the first check code.

9. The IRAM according to claim 8, wherein, the first control module is further configured to perform a format conversion on the reading/writing instruction.

10. The method according to claim 8, wherein, the first ECC module comprises: a first judgment submodule and a first coding submodule; wherein,
the first judgment submodule is configured to judge where there are invalid data in the data to be stored, in a case that there are invalid data in the data to be stored, obtain storage data corresponding to an operation address carried by the reading/writing instruction, and generate valid data to be stored according to the storage data; and
the first coding submodule is configured to perform ECC coding on the data to be stored to generate a first check code.

11. An integrated random access memory IRAM for reading data based on hamming code, comprising: a second control module, a second error checking and correcting ECC module and a second storage module; wherein,
the second control module is configured to analyze a received reading/writing instruction to obtain a reading/writing state of the reading/writing instruction;
the second ECC module is configured to, when determining that the reading/writing state is a reading state, obtain data to be obtained according to the reading/writing instruction, detect the data to be obtained by using error checking and correcting ECC coding to obtain a detection result, and directly send the data to be obtained, or send the data to be obtained after error correction, or trigger an alarm according to the detection result; and
the second storage module is configured to store the data to be obtained and a first check code corresponding to the data to be obtained.

12. The IRAM according to claim 11, wherein, the second control module is further configured to perform a format conversion on the reading/writing instruction.

13. The IRAM according to claim 11, wherein, the second ECC module comprises: a second coding submodule and a check submodule; wherein,
the second coding submodule is configured to obtain the data to be obtained and a first check code corresponding to the data to be obtained according to the reading/writing instruction, and perform ECC coding on the data to be obtained, to generate a second check code; and
the check submodule is configured to perform an XOR operation on the first check code and the second check code to generate an XOR result, directly send the data to be obtained, or send the data to be obtained after error correction, or trigger an alarm according to the XOR result.

14. The IRAM according to claim 13, wherein, the check submodule is configured to: in case one, when the XOR result is all-0 or there is a single bit 1, then directly send the data to be obtained; in case two: when a number of 0s and a number of 1s in the XOR result are equal, then send the data to be obtained after the error correction; if a case is not the case one or the case two, then trigger an alarm.
